**Europäisches Patentamt**

**European Patent Office**

**Office européen des brevets**

(19)

(11) Veröffentlichungsnummer: **0 164 801**
**B1**

(12) # EUROPÄISCHE PATENTSCHRIFT

(45) Veröffentlichungstag der Patentschrift:
29.11.89

(21) Anmeldenummer: 85200887.9

(22) Anmeldetag: 06.06.85

(51) Int. Cl.⁴: **G 01 N 24/02**, G 01 N 24/04, G 01 N 24/08

(54) Kernspinresonanzgerät mit einem Stellglied zur Anpassung oder zum Nachstimmen des Resonators.

(30) Priorität: 13.06.84 DE 3421830

(43) Veröffentlichungstag der Anmeldung:
18.12.85 Patentblatt 85/51

(45) Bekanntmachung des Hinweises auf die Patenterteilung:
29.11.89 Patentblatt 89/48

(84) Benannte Vertragsstaaten:
CH DE FR GB LI NL

(56) Entgegenhaltungen:
EP-A- 0 136 642
DE-A- 1 773 742
DE-A- 2 409 947
US-A- 4 095 168

JOURNAL OF PHYSICS E-SCIENTIFIC INSTRUMENTS, Band 14, Nr. 6, Juni 1981, Seiten 700-701, The Institute of Physics, Dorking, GB; M. PERIC et al.: "Simple RF matching for NMR coils in ENDOR spectrometers"

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL-5621 BA Eindhoven (NL)**

(84) Benannte Vertragsstaaten: **CH FR GB LI NL**

(72) Erfinder: **Röschmann, Peter, Steenbalken 13, D-2000 Hamburg 63 (DE)**

(74) Vertreter: **Hartmann, Heinrich, Dipl.-Ing. et al, Philips Patentverwaltung GmbH Wendenstrasse 35 Postfach 10 51 49, D-2000 Hamburg 1 (DE)**

**Beschreibung**

Die Erfindung betrifft ein Kernspinresonanzgerät mit einem Magneten zur Erzeugung eines homogenen statischen Hauptmagnetfeldes und einer Resonantoranordnung zur Erzeugung eines hochfrequenten, zum Hauptmagnetfeld zumindest annähernd senkrecht verlaufenden Magnetfeldes, mit wenigstens einem Stellantrieb, der auf ein Stellglied zur Anpassung des Resonators an einen Hochfrequenzgenerator und/oder zum Nachstimmen des Resonators einwirkt.

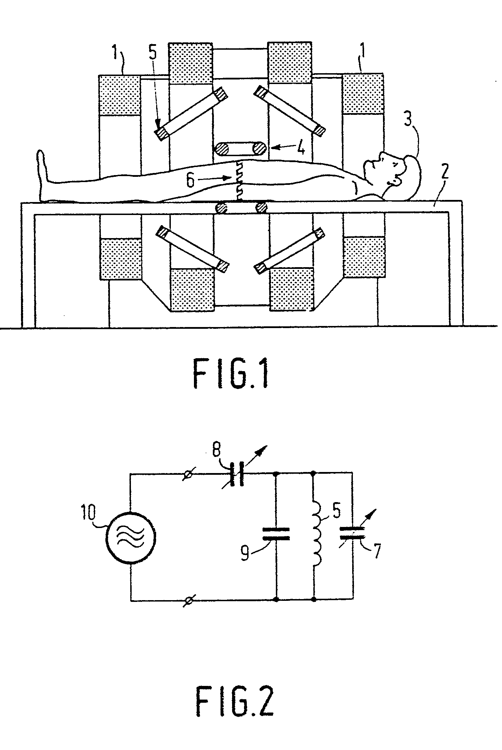

Ein Kernspintomographiegerät dieser Art ist in Fig. 1 dargestellt. Es umfasst einen aus vier Spulen bestehenden Elektromagneten, der ein statisches homogenes in Richtung der gemeinsamen horizontalen Spulenachse verlaufendes Magnetfeld erzeugt. Ein auf einer Tischplatte 2 im Innern des Elektromagneten gelagerter Patient 3 wird von einer Hochfrequenzspule 4 umschlossen, die ein senkrecht zu dem von dem Elektromagneten erzeugten Hauptmagnetfeld gerichtetes hochfrequentes Magnetfeld impulsweise erzeugt. Die Frequenz des hochfrequenten Magnetfeldes ist dabei der Flussdichte des Hauptmagnetfeldes, die je nach Ausführung des Elektromagneten zwischen 0,1 T und 2 T betragen kann, proportional; die Proportionalitätskonstante ist gleich dem gyromagnetischen Verhältnis. Daher können innerhalb des von der Hochfrequenzspule umschlossenen Volumens Kernspinresonanzen erzeugt werden. Vier sogenannte Gradientenspulen 5, die ein in Richtung des Hauptmagnetfeldes verlaufendes und sich in dieser Richtung linear änderndes Magnetfeld erzeugen, sorgen jedoch dafür, dass sich diese Anregung auf eine vertikale Schicht 6 beschränkt.

Wichtig bei derartigen Geräten ist, dass die Frequenz der von der Hochfrequenzspule erzeugten Schwingungen genau der durch das gyromagnetische Verhältnis und die Flussdichte des Hauptmagnetfeldes vorgegebenen Kernspinresonanzfrequenz entspricht, und dass der die Hochfrequenzspule 4 enthaltende Resonator stets an den die Hochfrequenzschwingungen liefernden Hochfrequenzgenerator angepasst ist.

Beim Einbringen des zu untersuchenden Patienten ergibt sich jedoch je nach Körpergrösse und Körperbereich eine Verstimmung der Resonanzfrequenz und eine Verringerung der Güte des Resonators. Dieser Effekt wird durch die dielektrischen Eigenschaften und die elektrische Leitfähigkeit des Körpergewebes hervorgerufen. Als Folge davon sind der Hochfrequenzgenerator bzw. der Hochfrequenzempfänger, der anschliessend an den Resonator angeschlossen wird und das in dem untersuchten Körperbereich entstehende Kernspinresonanzsignal aufnimmt, nicht mehr bei der sogenannten Kernspinresonanzfrequenz an den Resonator angepasst.

Es ist daher erforderlich, den Hochfrequenzgenerator nach dem Einbringen des Patienten und bevor mit der eigentlichen Kernspinresonanzuntersuchung begonnen wird, genau auf die vorgegebene Kernspinresonanzfrequenz nachzustimmen und an den Hochfrequenzgenerator anzupassen. Dies kann mit Hilfe der in Fig. 2 dargestellten Schaltung erfolgen. Der Resonator umfasst die Spule 5 sowie den Kondensator 9 und den Drehkondenstor 7, die der Spule 5 parallelgeschaltet sind. Der Kondensator 9 kann bei geeigneter Bemessung auch entfallen. Dieser Resonator ist über einen Drehkondenstor 8 an einen Hochfrequenzgenerator 10 angeschlossen. Die Anpassung erfolgt mit Hilfe des Drehkondensators 8 und die Abstimmung mit Hilfe des Drehkondensators 7, wobei sich beide Vorgänge gegenseitig beeinflussen.

Schwierig ist die Verstellung der Drehkondensatoren. Diese sind ausserhalb der Hochfrequenzspule im Innern des Elektromagneten angeordnet und können nicht durch Schrittmotoren oder dergleichen verstellt werden, weil deren ferromagnetische Teile die Homogenität des Magnetfeldes stören würden. Die Schrittmotoren müssen daher ausserhalb des Elektromagneten in solcher Entfernung angeordnet werden, dass sie die Homogenität des Hauptmagnetfeldes nicht stören und nicht durch die Streufelder des Elektromagneten in ihrer Funktion beeinträchtigt werden, und sie müssen über lange Antriebsstangen mit den im Innern des Elektromagneten angeordneten Stellgliedern gekoppelt werden. Es ist nicht möglich, auch die Stellglieder ausserhalb des Elektromagneten anzuordnen, weil sie dann mit dem Resonator im Inneren über elektrische Leitungen verbunden werden müssten, deren Länge – insbesondere bei hohen Magnetflussdichten bzw. hohen Kernspinresonanzfrequenzen – nicht mehr klein im Vergleich zur Wellenlänge ist, was Störungen zur Folge hätte.

Es ist Aufgabe der vorliegenden Erfindung, ein Kernspinresonanzgerät der eingangs genannten Art so auszugestalten, dass der Antrieb zum Verstellen der Stellglieder im Innern des Elektromagneten angeordnet werden kann, ohne dass dadurch die Homogenität des Hauptmagnetfeldes beeinträchtigt wird.

Diese Aufgabe wird dadurch gelöst, dass der Stellantrieb eine dem Hauptmagnetfeld ausgesetzte und beweglich gelagerte Spule enthält, dass die Spule an einen Stromimpulsgeber zur Erzeugung von Stromimpulsen der einen oder anderen Polarität angeschlossen ist, durch die die Spule in der einen oder anderen Richtung aus ihrer Ruhelage ausgelenkt wird, und dass die Auslenkbewegung auf das Stellglied über ein Schrittwerk übertragen wird, das die hin- und hergehende Bewegung der Spule in eine schrittweise Bewegung des Stellgliedes umsetzt, deren Richtung der Richtung der Auslenkung eindeutig zugeordnet ist.

Die Spule wird, wenn sie von einem Stromimpuls durchflossen wird, im Hauptmagnetfeld aus ihrer Ruhelage ausgelenkt und kehrt nach dem Stromimpuls – z.B. mit Hilfe von Rückstellfedern – in ihre Ruhelage zurück. Werden der Spule mehrere Stromimpulse der gleichen Polarität zugeführt, führt diese daher eine hin- und hergehende Bewegung aus. Diese wird mit Hilfe des Schrittwerkes in eine schrittweise (Dreh- oder Schub-) Bewegung des Stellgliedes umgesetzt, deren Richtung der Richtung der Auslenkung und damit der Polarität der Stromimpulse eindeutig zugeordnet ist. Ein solcher Stellantrieb benötigt keine ferromagnetischen Teile. Deshalb und weil die Leitungen vom Stromimpulsgeber zur Spule während der eigentlichen Messung stromlos bleiben können, beeinträchtigt ein solcher Stellantrieb die Feldhomogenität nicht.

Die Erfindung wird nachstehend anhand der Zeichnung näher erläutert. Es zeigen

Fig. 1 ein Kernspintomographiegerät, bei dem die Erfindung anwendbar ist,

Fig. 2 das Schaltbild des Resonators und des Hochfrequenzgenerators,

Fig. 3 ein erstes Ausführungsbeispiel,

Fig. 4 eine Draufsicht auf die Anordnung nach Fig. 3 längs der Linien A–B,

Fig. 5 eine andere Ausführungsform der Erfindung und

Fig. 6 eine Seitenansicht der Ausführungsform nach Fig. 5.

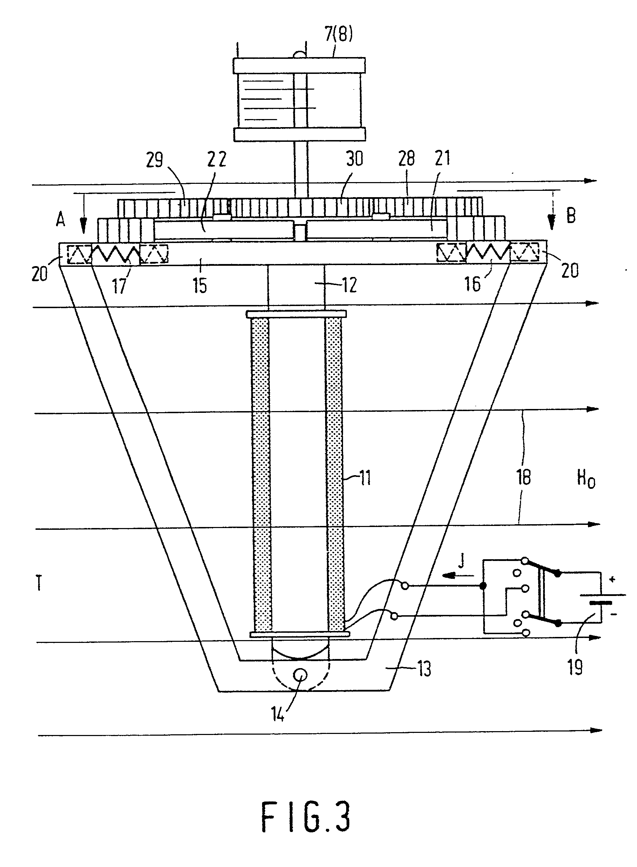

Nach Fig. 3 ist eine langgestreckte Solenoidspule 11 mit einem Halterungskörper 12 verbunden, der in einem Gehäuserahmen 13 an seinem unteren Ende um eine horizontale Achse 14 schwenkbar gelagert ist. Das obere Ende des Halterungskörpers 12 ist mit einem Steuerglied 15 so verbunden, dass eine Kippbewegung des Spulenkörpers 12 in eine Schubbewegung des Steuergliedes 15 umgesetzt wird, das in einer horizontal verlaufenden Führungsschiene 16 geführt ist. Zwei an den beiden Enden des Steuergliedes 15 angebrachte Federn bewirken, dass der Halterungskörper und mit ihm die Solenoidspule in der Ruhelage, d.h. wenn keine weiteren äusseren Kräfte auf sie einwirken, eine vertikale Position einnehmen. Die Spulenachse verläuft dann also senkrecht zu dem Hauptmagnetfeld, dessen Richtung in Fig. 3 durch die horizontal verlaufenden Pfeile 18 angedeutet ist.

Mit den Anschlüssen der Spule 11 ist ein Stromimpulsgeber 19 verbunden, der z.B. eine Gleichstromquelle enthalten kann, die über einen steuerbaren mehrpoligen Umschalter so mit den Anschlüssen verbunden werden kann, dass entweder Strom in der einen Richtung, kein Strom oder Strom in der entgegengesetzten Richtung durch die Spule 11 fliessen kann.

Wenn ein Stromimpuls die Spule 11 durchfliesst, wird in dieser ein Magnetfeld aufgebaut, das in Richtung der Spulenachse verläuft und somit senkrecht zum Hauptmagnetfeld steht. Infolgedessen wirkt dann auf die Spule eine Kraft ein, welche diese um die Achse 14 in Richtung des Hauptmagnetfeldes zu kippen sucht, d.h. je nach Polarität des Stromes durch die Spule entweder nach links oder nach rechts. Diese Kippbewegung der Spule wird über den Halterungskörper 12 auf ein Steuerglied 15 übertragen, das dadurch nach links bzw. nach rechts in der horizontal verlaufenden Führungsschiene 16 verschoben wird, wobei diese Bewegung durch die Anschläge 20 an den Enden der Führungsschiene, mit denen das Steuerglied 15 über die Federn 17 verbunden ist, begrenzt wird. Wenn mehrere Stromimpulse der gleichen Polarität der Spule 11 zugeführt werden, führt das Steuerglied 12 eine von der Mitte nach links (oder nach rechts) und zurückgehende Bewegung aus. Diese hin- und hergehende Bewegung wird durch das Schrittwerk in eine schrittweise Drehbewegung des Rotors des Drehkondensators 7 bzw. 8 umgesetzt, so dass dessen Polarität bei Stromimpulsen der einen Polarität schrittweise zunimmt und bei Stromimpulsen der anderen Polarität schrittweise abnimmt.

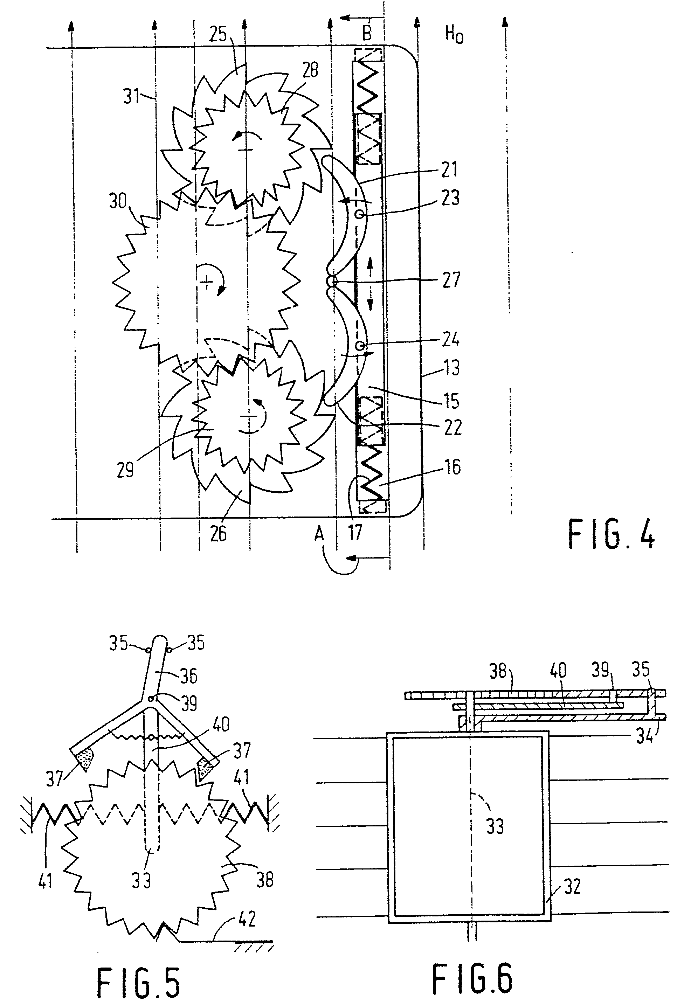

Wie hierzu aus Fig. 4 ersichtlich ist, ist das Steuerglied 15 mit zwei Klinken 21 bzw. 22 versehen, die symmetrisch zur Mittelstellung des Steuergliedes 15 angeordnet und um vertikale Lagerzapfen 23 bzw. 24 schwenkbar gelagert sind. Nicht näher dargestellte Federn sorgen dabei dafür, dass die voneinander abgewandten Enden der Steuerklinken gegen zwei Klinkenzahnräder 25 bzw. 26 gedrückt werden, die in Richtung des Magnetfeldes gegeneinander versetzt und symmetrisch zur Ruhelage des Steuergliedes 15 um eine vertikale Achse drehbar gelagert sind. Zwischen den einander zugewandten Enden der Steuerklinken 21 und 22 befindet sich ein Steuerzapfen 27, der fest mit dem Gehäuserahmen 13 verbunden ist.

Wird die Spule durch einen Stromimpuls erregt, durch den das Steuerglied 15 nach rechts (Fig. 3) bzw. nach oben (Fig. 4) verschoben wird, dann geschieht folgendes: Die Steuerklinke 21 folgt, da ihr eines Ende bei dieser Bewegung von dem Steuerzapfen 27 frei kommt, der Kontur des Klinkenzahnrades, bis es gegen eine der Flanken der Klinkenzähne stösst und das Klinkenzahnrad 25 um eine Zahnteilung im Gegenuhrzeigersinn dreht. Die andere Steuerklinke 22 wird durch diese Bewegung des Steuergliedes 15 gegen den Steuerzapfen 27 gedrückt, wobei diese Steuerklinke infolge der bananenförmigen Krümmung der dem Steuerzapfen 27 zugewandten Aussenkontur gleichzeitig eine Schwenkbewegung im Gegenuhrzeigersinn um den Lagerzapfen 24 ausführt, wodurch das andere Ende der Steuerklinke 22 das Klinkenzahnrad 26 freigibt. Die Schrittbewegung des Klinkenzahnrades 25 wird über ein Getriebezahnrad 28, das mit dem Klinkenzahnrad 25 fest verbunden und um die gleiche Achse drehbar ist wie dieses, auf ein Zahnrad 30 übertragen, das mit dem Rotor des Drehkondensators 7 bzw. 8 verbunden ist (Fig. 3). Das Zahnrad 30 steht in Eingriff mit einem Zahnrad 29, das mit dem Klinkenzahnrad 26 in gleicher Weise verbunden ist wie das Zahnrad 28 mit dem Klinkenzahnrad 25.

Infolge der Verschiebung des Steuergliedes wird also das Zahnrad 28 um eine Zahnradteilung im Gegenuhrzeigersinn gedreht, was einen von dem Übersetzungsverhältnis abhängigen Drehschritt im Uhrzeigersinn des Zahnrades 30 zur Folge hat, der eine Drehung des Zahnrades 29 und damit des Klinkenzahnrades 26 hervorruft, die genauso gross ist und in der gleichen Richtung verläuft, wie die des Klinkenzahnrades 25. Nach dem Ende des Stromimpulses kehrt das Steuerglied wieder in seine in den Figuren 3 und 4 dargestellte Ruhelage zurück, ohne dass sich dabei an der Stellung der Zahnräder etwas ändert. Ein erneuter Stromimpuls mit der gleichen Polarität bewirkt dann einen weiteren Drehschritt der Zahnräder in der gleichen Richtung.

Wie gestrichelt angedeutet, kann anstelle des Zahnrades 30, das mit dem Rotor des Drehkondensators verbunden ist, auch eine in Fig. 4 gestrichelt angedeutete Zahnstange 31 benutzt werden, die mit den Zahnrädern 28 und 29 in Eingriff steht und mit einem Dielektrikum verbunden ist, das – wie aus der DE-OS 3 347 597 bekannt – im Innern einer als Stichleitung wirkenden Koaxialleitung verschoben wird, so dass sich deren Reaktanz schrittweise ändert. Dabei wird also die translatorische, hin- und hergehende Bewegung des Steuergliedes 15 in eine schrittweise Schubbewegung der Zahnstange 31 umgesetzt.

In den Figuren 5 und 6 ist eine Ausführungsform dargestellt, bei der die Schwenkbewegung der Spule direkt und nicht über den Umweg einer translatorischen Bewegung umgesetzt wird. Die Spule, die eine oder mehrere Windungen mit beispielsweise rechteckförmigem Querschnitt umfasst, ist dabei um ihre zum Hauptmagnetfeld senkrecht verlaufende Symmetrieachse 33 drehbar gelagert und in der Ruhelage so angeordnet, dass die magnetischen Feldlinien des Hauptmagnetfeldes parallel zu der Spulenebene verlaufen.

Mit dem oberen Ende der Spule ist ein Mitnehmerhebel 34 fest verbunden, der in der Nähe seines Endes mit Mitnehmerzapfen 35 versehen ist, die den einen Arm eines dreiarmigen Ankers 36 umgreifen, dessen beide andere Arme mit Klinken 37 versehen sind, von denen jeweils eine mit einem Zahnrad 38 in Eingriff kommen kann. Der Anker 36 ist um eine zur Drehachse der Spule 32 parallele Achse 39 drehbar an einem weiteren Hebel 40 befestigt und seine beiden die Schaltklinken 37 tragenden Arme sind über Federn so mit diesem Hebel verbunden, das sie in der Ruhelage symmetrisch zu diesem Hebel stehen. Der Hebel 40 selbst wird wiederum durch Federn 41 in einer Ruhelage gehalten. Der Hebel 34 bzw. die Spule 32, das Zahnrad 38 und der weitere Hebel 40 sind um die gleiche Achse unabhängig voneinander drehbar gelagert.

Wenn die Spule 32 von einem Stromimpuls durchflossen wird, führt sie infolge der Kraftwirkung des magnetischen Feldes auf ihre stromdurchflossenen Leiter eine Drehbewegung aus, deren Richtung von der Polarität des Stromes in der Spule abhängt. Dabei wird der Mitnehmerhebel 34 ausgelenkt, der über die Mitnehmerzapfen 35 seinerseits zunächst den Anker 36 um die Achse 39 schwenkt, bis die eine der beiden Klinken 37 mit den Zähnen des Zahnrades 38 in Eingriff kommt. Danach wird über den Anker 36 der Hebel 40 gegen die Kräfte der Federn 41 in der gleichen Richtung geschwenkt, so dass das Zahnrad 38 einen Drehschritt ausführt. Nach dem Abklingen des Stromimpulses werden der Hebel 40, der Anker 36 und damit auch der Mitnehmerhebel 34 wieder in die Ruhelage zurückgestellt, wobei ein Rastgesperre 42 dafür sorgt, dass das Zahnrad 38 seine nach dem Drehschritt erreichte Position beibehält. Beim nächsten Stromimpuls wird das Zahnrad 38 erneut um eine Zahnteilung weiter in der gleichen Richtung verstellt.

Auf diese Weise wird die hin- und hergehende Schwenkbewegung des Mitnehmerhebels 34 bzw. der Spule 32 bei Erregung der Spule durch Stromimpulse einer bestimmten Polarität in eine schrittweise Drehbewegung des Zahnrades 38 umgesetzt. Diese kann direkt auf den Rotor eines Drehkondensators übertragen werden oder über eine Zahnstange in eine lineare Schrittbewegung umgesetzt und zur Verstellung einer Stichleitung benutzt werden.

Die Erfindung nutzt also zur Erzeugung einer Verstellung des Stellgliedes die Kräfte aus, die von dem Hauptmagnetfeld auf eine stromdurchflossene Spule ausgeübt werden. Der erfindungsgemässe Stellantrieb enthält lediglich nichtmagnetisches Material und nach der Anpassung bzw. der Nachstimmung fliesst kein Strom mehr durch die Spule, so dass bei den anschliessenden Kernspinresonanzmessungen keine Störfelder entstehen können, die die Homogenität des Hauptmagnetfeldes beeinflussen könnten. Dieser Stellantrieb, der mit der Hochfrequenzspule 4 (Fig. 1) baulich vereinigt und mit dieser gegen eine andere Hochfrequenzspule mit entsprechendem Stellantrieb ausgetauscht werden kann, eignet sich sehr gut zur automatischen Anpassung bzw. Nachstimmung mit Hilfe eines Rechners, weil zum Antrieb lediglich Stromimpulse in der erforderlichen Anzahl erzeugt werden müssen.

**Patentansprüche**

1. Kernspinresonanzgerät mit einem Magneten zur Erzeugung eines homogenen statischen Hauptmagnetfeldes und einer Resonatoranordnung zur Erzeugung eines hochfrequenten, zum Hauptmagnetfeld zumindest annähernd senkrecht verlaufenden Magnetfeldes, mit wenigstens einem Stellantrieb, der auf ein Stellglied zur Änderung der Anpassung des Resonators an einen Hochfrequenzgenerator und/oder zum Nachstimmen des Resonators einwirkt, dadurch gekennzeichnet, dass der Stellantrieb eine dem Hauptmagnetfeld ausgesetzte und beweglich gelagerte Spule (11, 32) enthält, dass die Spule an einen Stromimpulsgeber (19) zur Erzeugung von Stromimpulsen der einen oder anderen Polarität angeschlossen ist, durch die die Spule in der einen oder anderen Richtung aus ihrer Ruhelage ausgelenkt wird, und dass die Auslenkbewegung auf das Stellglied (7, 8) über ein Schrittwerk (21 30; 34 42) übertragen wird, das die hin- und hergehende Bewegung der Spule in eine schrittweise Bewegung des Stellgliedes umsetzt, deren Richtung der Richtung der Auslenkung eindeutig zugeordnet ist.

2. Kernspinresonanzgerät nach Anspruch 1, dadurch gekennzeichnet, dass die Spule (32) um eine zum Hauptmagnetfeld senkrechte, zur Spulenebene parallele Achse (14) schwenkbar gelagert ist, und dass sich die Spulenebene in ihrer Ruhelage parallel zur Richtung des Magnetfeldes (18) erstreckt.

3. Kernspinresonanzgerät nach Anspruch 1, dadurch gekennzeichnet, dass das Stellglied ein Drehkondensator (7, 8) ist und dass das Schrittwerk die hin- und hergehende Bewegung der Spule in eine schrittweise Drehbewegung umsetzt.

4. Kernspinresonanzgerät nach Anspruch 1 oder 2, dadurch gekennzeichnet, dass das Stellglied eine Stichleitung umfasst, deren Eigenschaften mittels eines verschiebbaren Dielektrikums veränderbar sind, und dass die hin- und hergehende Bewegung vom Schrittwerk in eine schrittweise Schubbewegung umgesetzt wird.

## Claims

1. A nuclear spin resonance apparatus comprising a magnet for generating a uniform steady main magnetic field and a resonator arrangement for generating an RF magnetic field which extends at least substantially perpendicularly to the main magnetic field, with at least one adjusting drive which acts on an adjusting member for matching the resonator to an RF generator and/or for adjusting the resonator, characterized in that the adjusting drive comprises a movably supported coil (11, 32) which is exposed to the main magnetic field, that the coil is connected to a current-pulse supply source (19) for producing current pulses of one polarity or the other polarity whereby the coil is deflected out of its rest position in one direction or the other direction, and in that the deflection movement is transmitted to the adjusting member (7, 8) via a stepping mechanism (21, ... 30; 34, ... 42) which converts the reciprocating movement of the coil into a stepwise movement of the adjusting member, which stepwise movement has a direction which is unambiguously associated with the direction of the deflection.

2. A nuclear spin resonance apparatus as claimed in Claim 1, characterized in that the coil (32) is arranged so as to be pivotable about an axis (14) which is perpendicular to the main magnetic field and parallel to the plane of the coil, and that the plane of the coil extends parallel to the direction of the magnetic field (18) in the rest position of the coil.

3. A nuclear spin resonance apparatus as claimed in Claim 1, characterized in that the adjusting member is a variable capacitor (7, 8) and that the stepping mechanism converts the reciprocating movement of the coil into a stepwise rotary movement.

4. A nuclear spin resonance apparatus as claimed in Claim 1 or 2, characterized in that the adjusting member comprises a stub line whose properties are variable by means of a slidable dielectric, and in that the stepping mechanism converts the reciprocating movement into a stepwise sliding movement.

## Revendications

1. Appareil à résonance magnétique nucléaire comportant un aimant pour la production d'un champ magnétique principal statique homogène et un montage de résonateur pour la production d'un champ magnétique haute fréquence s'étendant au moins à peu près perpendiculairement au champ magnétique principal, comportant au moins un actionneur qui agit sur un élément de réglage pour modifier l'adaptation du résonateur à un générateur haute fréquence et/ou pour corriger l'accord du résonateur, caractérisé en ce que l'actionneur contient une bobine (11, 32) exposée au champ magnétique principal et montée mobile, que la bobine est connectée à un générateur d'impulsions de courant (19) pour la production d'impulsions de courant de l'une ou de l'autre polarité, par lesquelles la bobine est déviée dans un sens ou dans l'autre à partir de sa position de repos et que le mouvement de déviation est transmis à l'élément de réglage (7, 8) par l'intermédiaire d'un mécanisme pas à pas (21, ... 30; 34, ... 42) qui convertit le mouvement de va-et-vient de la bobine en un mouvement pas à pas de l'élément de réglage dont les sens est associé de manière univoque au sens de la déviation.

2. Appareil à résonance magnétique nucléaire suivant la revendication 1, caractérisé en ce que la bobine (32) est montée pivotante autour d'un axe (14) parallèle au plan de la bobine et perpendiculaire au champ magnétique principal, et que le plan de la bobine s'étend, dans sa position de repos, parallèlement à la direction du champ magnétique (18).

3. Appareil à résonance magnétique nucléaire suivant la revendication 1, caractérisé en ce que l'élément de réglage est un condensateur variable (7, 8) et que le mécanisme pas à pas convertit le mouvement de va-et-vient de la bobine en un mouvement de rotation pas à pas.

4. Appareil à résonance magnétique nucléaire suivant la revendication 1 ou 2, caractérisé en ce que l'élément de réglage comprend une ligne de dérivation dont les propriétés peuvent être modifiées au moyen d'un diélectrique déplaçable et que le mouvement de va-et-vient est converti par le mécanisme pas à pas en un mouvement de glissement pas à pas.

FIG.1

FIG.2

7(8)

29  22  30  28  21

A

B

20  17  15  12  16  20

11

18  H₀

T

J

13

14  19

# FIG.3

FIG. 4

FIG.5

FIG.6

11